# EUROPÄISCHE PATENTSCHRIFT

(11) **EP 0 302 813 B1**
(45) Veröffentlichungstag und Bekanntmachung des Hinweises auf die Patenterteilung: **09.08.1995**
(21) Anmeldenummer: 88710010.5
(22) Anmeldetag: 10.05.1988
(51) Int. Cl.: B05D 1/32, C08J 7/00, B44C 1/14

(54) **Folie mit mindestens einer ein Sichtfenster aufweisenden metallisierten Oberfläche sowie Verfahren und Vorrichtung zu ihrer Herstellung**
Sheet having a metallized surface with a window, method and apparatus for its manufacture
Feuille ayant une surface métallisée avec une fenêtre, procédé et appareil pour sa fabrication

(30) Priorität: 11.05.1987 DE 3715640
(43) Veröffentlichungstag der Anmeldung: 08.02.1989
(73) Patentinhaber: Schmoock, Helmuth, D-21481 Lauenburg (DE)
(72) Erfinder: Schmoock, Helmuth, D-21481 Lauenburg (DE)
(74) Vertreter: Heldt, Gert, Dr. Dipl.-Ing.

(56) Entgegenhaltungen:
- DE-U- 8 608 399
- GB-A- 2 107 361
- US-A- 3 846 172
- US-A- 3 935 334
- US-A- 4 242 378

## Beschreibung

Die Erfindung betrifft ein Verfahren zur Herstellung einer Folie, die auf mindestens einer ihrer Oberflächen eine von mindestens einem Sichtfenster unterbrochene Metallschicht aufweist, das in einem mit einer löslichen Abdeckschicht bedeckten Bereich der Oberfläche aus der Metallschicht herausgelöst wird, die auf die Oberfläche im Vakuum aufgedampft wird.

Aus der GB-A-2 107 361 ist ein Verfahren zur Herstellung einer Folie bekannt, die auf mindestens einer ihrer Oberflächen eine von mindestens einem Sichtfenster unterbrochene Metallschicht aufweist, das in einem mit einer löslichen Abdeckschicht bedeckten Bereich der Oberfläche aus der Metallschicht herausgelöst wird, die auf die Oberfläche im Vakuum aufgedampft wird. Zu diesem Zwecke wird auf die Folie eine Haftschicht aufgetragen. Diese bedeckt diejenigen Teile der Folie nicht, an denen ein Sichtfenster angebracht werden soll. Sodann können auf diese Haftschicht weitere Schichten, beispielsweise eine Tinten- bzw. Farbschicht aufgetragen werden. Auch diese Auftragung der Tinten- bzw. Farbschicht erfolgt in der Weise, daß das Sichtfenster frei bleibt.

Erst nachdem die Folie in dieser Weise beschichtet worden ist, wird im Bereich des Sichtfensters eine Wasserfarbe aufgetragen. Sodann wird auf die gesamte Oberfläche eine Metallschicht aufgebracht. Diese wird im Bereich der Wasserfarbschicht anschließend dieser abgespült, so daß an dieser Stelle ein Fenster freigegeben wird.

Dieses Verfahren setzt voraus, daß die einzelnen Schichten sehr exakt aufgetragen werden, damit die künftigen Fenster an den geplanten Stellen der Folie liegen. Sobald sich die Schichten gegeneinander verschieben, entsteht ein unsauberer Rand für die Fenster. Deren Querschnitt wird unter das gewünschte Maß verringert, wenn die eine Schicht im Bereich des Randes über die andere Schicht vorsteht. Falls die Metallschicht nicht genau an den Grenzen des Fensters mit der Tinten- bzw. Farbschicht abbindet, ist die Metallschicht nicht fest mit den den Fenstern benachbarten Bereichen verbunden. Sie hebt sich aufgrund von mechanischen Belastungen von der metallisierten Folie ab. Diese Ablösung könnte sich auf die gesamte aufgedampfte Metallschicht erstrecken.

Dieses Verfahren ist nicht nur teuer, sondern führt darüber hinaus auch nur zu mäßigen Erfolgen. Exakte Begrenzungen des Sichtfensters können nur mit einem hohen Aufwand und sehr genau arbeitenden Druckmaschinen hergestellt werden. Trotzdem besteht die Gefahr, daß das nach Aufbringung der Haftschicht und der Farbschicht aufgedruckte Abdeckmittel die Ränder des Sichtfensters benetzt, so daß an diesen Rändern die aufgedampfte Metallschicht nicht ordnungsgemäß abbinden kann.

Aus der US-PS 3 935 334 ist ein Verfahren zur Herstellung von Kondensatorelementen bekannt, bei dem auf eine dielektrische Harzschicht eine Leiterschicht aus einer aufgedampften Metallschicht aufgetragen wird. Diese Leiterschicht soll nach einem bestimmten Muster aufgetragen werden.

Zu diesem Zwecke wird auf die dielektrische Harzschicht eine wasserlösliche Beschichtung aufgebracht, auf die eine Metallschicht aufgedampft wird. Anschließend wird die aufgedampfte Metallschicht im Bereich der wasserlöslichen Schicht mit Wasser abgelöst, so daß die Metallschicht nur im Bereich der Harzschicht erhalten bleibt.

Die wasserlösliche Schicht besitzt eine Dicke, die sich bevorzugt in den Grenzen von 1 bis 2 »m bewegt. Darüber hinaus werden zur Herstellung der wasserlöslichen Schicht konventionelle wasserlösliche oder wäßrige Substanzen empfohlen, die als Hauptkomponente wasserlösliche Harze enthalten.

Die Anwendung dieses Verfahrens ist zur Herstellung von Sichtfenstern in Verpackungsfolien nicht anwendbar. Verpackungsfolien besitzen eine unterschiedlich große Anzahl von Beschichtungen, die von der Trägerfolie abgelöst werden müssen, beispielsweise Harzschichten, Farbschichten und Metallschichten. Gelegentlich müssen verschiedene Tiefen für Sichtfenster entstehen. In manchen Bereichen der Folie reichen diese bis auf die Trägerfolie, während sie an anderen Stellen im Bereich des Sichtfensters eine durchgehende Schicht aufweisen, beispielsweise eine Farbschicht. In manchen Bereichen wird daher nur eine Schicht, in anderen Bereichen aber mehrere Schichten von der Trägerfolie abgelöst. Für jeden Anwendungsfall muß die aufgetragene wasserlösliche Schicht den gewünschten Ablösungseffekt erbringen. Dazu ist das Verfahren der US-PS 3 935 334 nicht geeignet.

Schließlich ist aus der US-PS 4 242 378 ein Verfahren zur Herstellung von Dekorationsmaterial bekannt. Dabei wird überschüssiges Metall, das ganzflächig auf eine Harzschicht aufgedampft wird, mit Hilfe einer metallablösenden Flüssigkeit abgelöst. Diese Methode ist wenig umweltfreundlich und nicht in der Lage, exakte Begrenzungen der Sichtfenster herbeizuführen.

Darüber hinaus beschreibt diese Druckschrift die Verwendung eines wasserlöslichen Harzes, das auf die Oberfläche eines Basismaterials aufgedruckt wird, um ein negatives Muster auszuformen. Sodann wird die gesamte Oberfläche des Trägermaterials mit Metall beschichtet und anschließend die wasserlösliche Schicht mit Wasser angelöst, so daß sich in ihrem Bereich die Metallschicht von ihrer Unterfläche löst. Die Verwendung von Harzen macht diese Methode zur Herstellung von Dekorationsmaterial für die moderne technische Anwendung ungeeignet.

Aufgabe der vorliegenden Erfindung ist es daher, das Verfahren der einleitend genannten Art so zu verbessern, daß mit geringem Aufwand eine qualitativ hochwertige Folie mit einem Sichtfenster umweltschonend hergestellt werden kann.

Diese Aufgabe wird erfindungsgemäß dadurch gelöst, daß die Oberflächenspannung der Abdeckschicht mit einem Benetzungsmittel herabgesetzt wird, durch das eine Oberflächenstruktur der die Abdeckschicht bildenden Substanz vergrößert wird und auf die Abdeckschicht ein Lösungsmittel aufgetragen und dadurch die Abdeckschicht abgelöst wird.

Mit Hilfe dieses Verfahrens wird in der Metallschicht einer Folie ein sehr exakt abgegrenztes Sichtfenster erzeugt, ohne daß aufwendige Mehrschichtendruckverfahren notwendig sind. Die Abdeckschicht wird auf beliebige Weise, beispielsweise mit einem einfachen Druckverfahren an den mit dem Sichtfenster zu versehenden Stellen aufgebracht. Unmittelbar nach der Benetzung der Abdeckschicht mit einem Lösungsmittel, das im Regelfall Wasser sein wird, löst sich die aufgebrachte Metallschicht von der Abdeckschicht und wird exakt an den Grenzen der aufgetragenen Abdeckschicht abgelöst.

Die genaue Ablösung erfolgt unabhängig davon, ob die Abdeckschicht unmittelbar auf die mit dem Sichtfenster zu versehende Folie oder auf eine Zwischenschicht, beispielsweise eine Haftschicht aufgetragen wird. Die ablösende Wirkung der auf diese Weise aufgetragenen Abdeckschicht tritt auch dann noch ein, wenn auf die Abdeckschicht nicht unmittelbar die abzulösende Metallschicht, sondern zunächst noch eine andere Zwischenschicht, beispielsweise eine Tinten- bzw. Farbschicht aufgetragen wird. Durch die Beimischung eines Benetzungsmittels zur Substanz der Abdeckschicht wird erreicht, daß diese Abdeckschicht so begierig das Lösungsmittel annimmt, daß dieses nicht nur durch die Metallschicht, sondern auch durch beliebige andere Schichten, beispielsweise durch eine Tinten- bzw.Farbschicht hindurch diffundiert und spontan die Substanz der Abdeckschicht anlöst, so daß im Bereich dieser Abdeckschichten die Haftung der Schichten bzw. der Schicht aufgehoben wird.

Auf diese Weise ist es möglich, mit nur einem Druckvorgang eine Abdeckschicht aufzutragen, mit deren Hilfe durch eine oder mehrere Schichten hindurch ein Sichtfenster in der Folie erzeugt wird. Darüber hinaus besitzt die Abdeckschicht den großen Vorteil, daß sie das Sichtfenster exakt begrenzt, so daß die Metallschicht bzw. andere Schichten an den Grenzen der Abdeckschicht fest auf der Trägerfolie haften.

Darüber hinaus betrifft die Erfindung eine Folie mit einer Oberfläche, die mit einer Metallschicht bedeckt ist, von der mindestens ein Teil über mindestens eine wasserlösliche Abdeckschicht auf der Oberfläche haftet und die Metallschicht unter Verwendung von Wasser ablösbar ist.

Bei der Herstellung dieser Folie ist jedoch die Verwendung von Harzen erforderlich, die umweltbelastende Eigenschaften aufweisen. Darüber hinaus werden erhebliche Mengen an Wasser zur Durchführung des Herstellungsverfahrens benötigt.

Um diesem Mangel abzuhelfen, besteht die Abdeckschicht aus einer mit einem beigemischten Benetzungsmittel versehenen Substanz, die eine durch das Benetzungsmittel vergrößerte Oberflächenstruktur aufweist und gemeinsam mit der sie bedeckenden Metallschicht durch eine Zugabe von Wasser von ihrem Untergrund ablösbar ist.

Die Abdeckschicht verhindert einen unmittelbaren Kontakt der Metallschicht im Bereich des Sichtfensters mit der Folienoberfläche. Die Metallschicht haftet vielmehr im Bereich des Sichtfensters lediglich auf der Abdeckschicht und kann gemeinsam mit dieser durch Einwirkung eines Lösungsmittels von der Folie entfernt werden. Da durch das Lösungsmittel lediglich die Abdeckschicht, nicht aber durch chemische Reaktionen die Metallschicht abgelöst wird, werden die Kanten der Metallschicht in Richtung auf das Sichtfenster durch den Ablösevorgang nicht beeinträchtigt. Ein Unterätzen der Kanten wird wirksam vermieden.

Schließlich betrifft die Erfindung eine Vorrichtung zur Herstellung einer Folie, die eine Metallisierungseinrichtung zur Bedampfung mindestens einer Oberfläche der Folie mit einer Metallschicht und eine in Förderrichtung der Folie hinter der Metallisierungseinrichtung angeordnete Lösungsmittelstation zur Ablösung mindestens eines Teils der Metallschicht von einer Abdeckschicht aufweist, die aus einer wasserlöslichen Substanz besteht und von einem Druckwerk aufgedruckt wird, das in Förderrichtung der Folie vor der Metallisierungseinrichtung angeordnet ist, zwischen der und dem Druckwerk ein Primärtrockner angeordnet ist.

Bei bekannten Vorrichtungen dieser Art wird die Metallschicht im Bereich der Sichtfenster durch die Einwirkung von in Ätzbädern enthalter Chemikalien von der Folie entfernt. Die in diesen Bädern gelösten Chemikalien treten mit der Metallschicht im Bereich des Sichtfensters in eine chemische Reaktion und überführen die Metallschicht in eine chemische Verbindung. Die Verwendung dieser Chemikalien sowie die Entsorgung der bei der Ablösung entstehenden chemischen Verbindung ist wegen der aus Gründen des Umweltschutzes gebotenen Sorgfalt mit erheblichen Kosten belastet.

Um diese einzusparen, ist erfindungsgemäß zwischen dem Primärtrockner und dem Druckwerk mindestens ein weiteres Druckwerk zum Aufdruck weiterer Schichten vorgesehen, die zwischen der mit einer oberflächenvergrößernden Substanz versehenen Abdeckschicht und der Metallschicht angeordnet sind, und in der Lösungsmittelstation ist eine die Metallschicht unter dem Einfluß eines Lösungsmittels von der Abdeckschicht ablösende Ablösevorrichtung vorgesehen.

Mit Hilfe der Lösungsmittelstation wird die lösliche Abdeckschicht und zusammen mit dieser die Metallisierungsschicht im Bereich des Sichtfensters von der Folie entfernt. Dabei wird lediglich die Abdeckschicht in einen gelösten Zustand überführt. Die Metallschicht wird zwar gemeinsam mit der Abdeckschicht von der Folie entfernt, sie geht jedoch nicht selber in einen gelösten Zustand über und kann daher auf einfache Weise aus dem Lösungsmittel entfernt und gesondert entsorgt werden. Aufgrund der großen Oberfläche der die Abdeckschicht bildenden Substanz kann die Metallschicht relativ dünn je Flächeneinheit ausgebildet werden, so daß sie sich leicht gemeinsam mit der Deckschicht in kurzer Zeit ablösen läßt.

Weitere Einzelheiten der Erfindung ergeben sich aus der nachfolgenden ausführlichen Beschreibung und den beigefügten Zeichnungen, in denen bevorzugte Ausführungsformen der Erfindung beispielsweise veranschaulicht sind.

In den Zeichnungen zeigen:

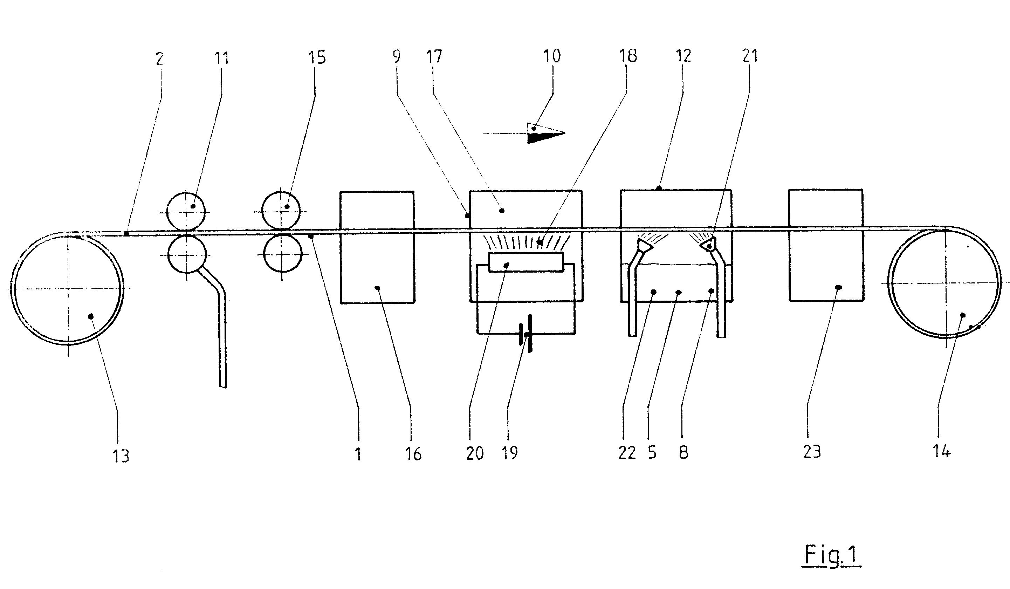

- Fig. 1:: eine Skizze einer Vorrichtung zur Herstellung einer Folie,

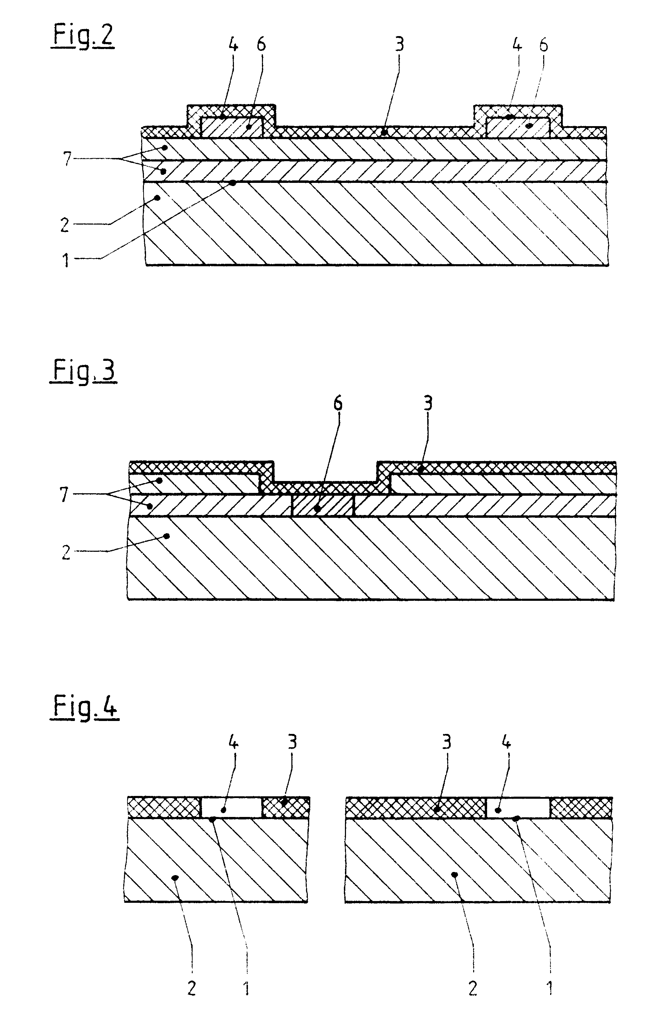

- Fig. 2:: einen Querschnitt durch eine Folie, deren Oberfläche mit zwei Zwischenschichten bedeckt und die mit einer Abdeckschicht versehen ist sowie von einer Metallschicht überzogene Schicht,
- Fig. 3:: einen Querschnitt durch eine Folie, die zwei Zwischenschichten aufweist und bei der sich die Abdeckschicht in einer Ebene mit der der Folie zugewandten Zwischenschicht erstreckt,

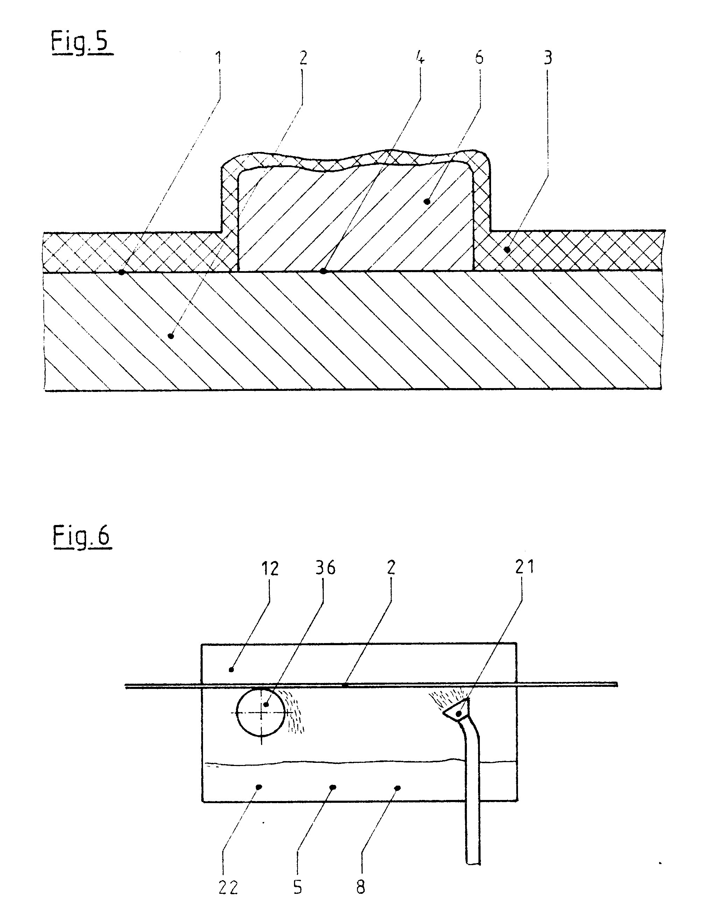

- Fig. 4:: einen Querschnitt durch eine Folie, bei der die Metallschicht unmittelbar auf der Oberfläche der Folie angeordnet ist und bei der die Abdeckschicht gemeinsam mit der auf ihr aufhaftenden Metallschicht von der Folienoberfläche die Sichtfenster freigebend abgelöst ist,
- Fig. 5:: einen vergrößerten Querschnitt durch eine Folie,bei bei der die Metallschicht unmittelbar auf der Oberfläche der Folie angeordnet ist und die gleichfalls unmittelbar auf der Folienoberfläche angeordnete Abdeckschicht im Bereich eines Sichtfensters überzieht,
- Fig. 6:: einen Querschnitt einer Lösungsmittelstation mit Ablösewalze und Sprühkopf,

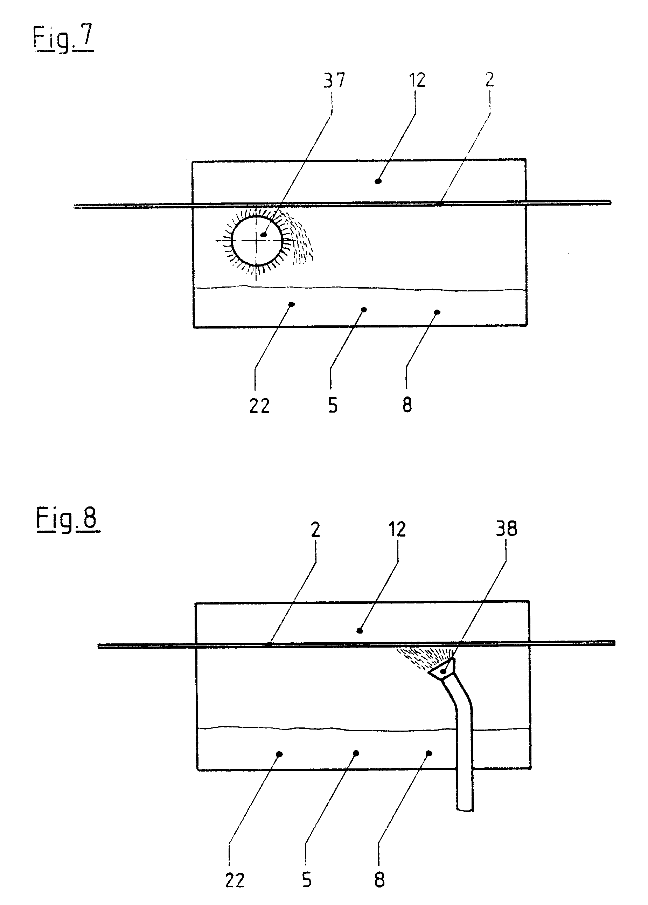

- Fig. 7:: einen Querschnitt einer Lösungsmittelstation mit Ablösebürste,
- Fig. 8:: einen Querschnitt einer Lösungsmittelstation mit Ablösedampfdüse,

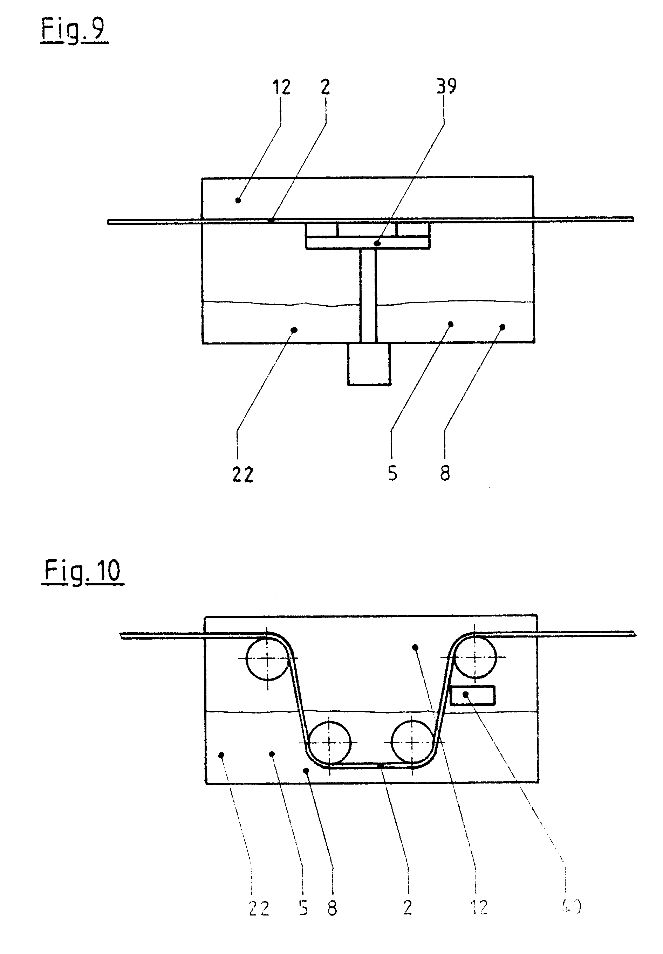

- Fig. 9:: einen Querschnitt einer Lösungsmittelstation mit die Folie wischend beaufschlagender Ablösewischvorrichtung und
- Fig.10:: einen Querschnitt einer Lösungsmittelstation mit über Umlenkwalzen durch ein Tauchbad geführter Folie.

Im Bereich einer Oberfläche (1) einer Folie (2) ist eine Metallschicht (3) angeordnet, die fest auf der Oberfläche (1) haftet. Im Bereich eines Sichtfenster (4), das im Bereich der Oberfläche (1) vorgesehen ist, ist eine in einem Lösungsmittel (5) lösliche Abdeckschicht (6) angeordnet. Die Abdeckschicht (6) ist wasserlöslich ausgebildet.

Die Abdeckschicht (6) ist als eine eine große Oberfläche aufweisende Substanz ausgebildet. Die Abdeckschicht (6) enthält dazu einen Anteil von die Oberfläche vergrößernden Produkten, die zu einer vergrößerten Oberflächenstruktur führen. Es ist aber auch möglich, andere Zusätze vorzusehen oder die Abdeckschicht ohne die Oberfläche vergrößernde Zusätze auszubilden.

Es ist auch möglich, die Metallschicht (3) mindestens bereichsweise nicht unmittelbar auf der Oberfläche (1) anzuordnen, sondern zwischen der Oberfläche (1) und der Metallschicht (3) eine oder mehrere Zwischenschichten (7) vorzusehen. Die Zwischenschichten (7) sind als Lack ausgebildet, der die Folie im Bereich der Sichtfenster (4) farbig ausgestaltet.

Die Folie kann beispielsweise als Polyvenylchlorid, Polyäthylen, Polyester, Polystyrol oder Polypropylen ausgebildet sein. Als Lösungsmittel (5) kommt insbesondere mit einem Benetzungsmittel (8) versetztes Wasser in Betracht. Die Abdeckschicht ist vorzugsweise als ein Gemisch aus wasserlöslichen Produkten ausgebildet ist, das mit die Oberfläche vergrößernden Produkten angereichert ist. Es ist auch möglich, nicht mit einem Benetzungsmittel (8) versetztes Wasser als Lösungsmittel (5) vorzusehen.

Eine Vorrichtung zur Herstellung der Folie (1) besteht im wesentlichen aus einer die Folie metallisierenden Metallisierungseinrichtung (9), einem in Transportrichtung (10) der Folie (2) vor der Metalliserungseinrichtung (9) angeordneten, die Abdeckschicht (6) aufdruckenden Druckwerk (11) und einer in Transportrichtung (10) hinter der Metalliserungseinrichtung (9) angeordneten Lösungsmittelstation (12). Die Folie (2) ist vor ihrer Zuführung in die sie bearbeitende Vorrichtung auf einer Primärrolle (13) aufgewickelt, nach dem Abschluß ihrer Bearbeitung wird sie einer Sekundärrolle (14) zugeführt. Zwischen dem Druckwerk (11) und der Metalliserungseinrichtung (9) ist ein die Zwischenschicht (7) aufdruckendes Druckwerk (15) angeordnet. Es ist auch möglich, in Transportrichtung (10) mehrere Druckwerke (15) hintereinander anzuordnen und mehrere Zwischenschichten (7) übereinander zu drucken. zwischen dem Druckwerk (15) und er Metallisierungseinrichtung (9) ist ein die bedruckte Folie trocknender Primärtrockner (16) angeordnet.

Im Bereich der Metallisierungseinrichtung (9) ist ein Vakuum (17) vorgesehen, in dem ein Metalldampf (18) erzeugender Verdampfer (19) angeordnet ist. Der Verdampfer (19) ist mit einer ihn speisenden Energieversorgung (20) verbunden.

Im Bereich der Lösungsmittelstation (12) ist ein das Lösungsmittel (5) in Richtung auf die metallisierte Oberfläche der Folie (2) sprühender Sprühkopf (21) angeordnet. Es ist auch möglich, mehrere Sprühköpfe (21) vorzusehen, die eine zuverlässige Ablösung sämtlicher Bestandteile der Abdeckschicht (6) gewährleisten. Es ist gleichfalls möglich, statt die Folie (1) mittels der Sprühköpfe (21) zu besprühen, die Folie (1) durch ein Lösungsmittelbad (22) hindurchzuleiten, sowohl die Hindurchleitung der Folie (2) durch ein Lösungsmittelbad (22) als auch die Folie besprühende Sprühköpfe (21) vorzusehen, oder das Lösungsmittel aufzuwalzen. Es ist darüber hinaus möglich, zur Beaufschlagung der Folie (1) mit Lösungsmittel (5) und zum Abtragen der abzulösenden Metallschicht mindestens eine Bürste (60), oder eine Ablösewischvorrichtung (39) vorzusehen. Des weiteren kann das Lösungsmittel (5) von Ablösedampfdüsen (38) dampfförmig auf die Oberfläche (1) der Folie (2) aufgebracht werden.

Zwischen der Lösungsmittelstation (12) und der Sekundärrolle (14) ist ein die Folie (2) vor ihrer Abwicklung trocknender Sekundärtrockner (23) angeordnet. Es ist darüber hinaus möglich, den Abtrag der Metallschicht durch reibende Beaufschlagung der Folie mit Bürsten oder Schwämmen zu unterstützen.

Die Folie (2) wird vor ihrer Bedruckung mit der Abdeckschicht (6) im Bereich des Druckwerkes (11) zunächst von der Primärrolle (13) abgewickelt. Im Bereich des Druckwerks (11) wird an dafür vorgesehenen Stellen der Oberfläche (1) die Abdeckschicht (6) aufgedruckt. Im Anschluß an den Aufdruck der Abdeckschicht (6) wird die Oberfläche (1) im Bereich der dafür vorgesehenen Flächen vom Druckwerk (15) mit der Zwischenschicht (7) bedruckt. Es ist auch möglich, die Folie (2) mit Hilfe mehrerer hintereinander geschalteter Druckwerke (15) mit mehreren übereinander angeordneten Zwischenschichten (7) zu versehen. Es ist darüber hinaus möglich, Druckwerke (15) in Transportrichtung (10) vor dem Druckwerk (11) anzuordnen und die Abdeckschicht (6) auf eine oder mehrere Zwischenschichten (7) aufzubringen. Nach einer Ablösung der Abdeckschicht (6) im Bereich der Lösungsmittelstation (12) wird durch das Sichtfenster (4) dann der Blick auf die in der Regel eingefärbte Zwischenschicht (7) freigegeben.

Vor der Bedampfung der Oberfläche (1) im Bereich der Metalliserungseinrichtung (9) wird die Folie (2) im Bereich des Primärtrockners (16) getrocknet und damit eine Verunreinigung des Vakuums (17) im Bereich der Metallisierungseinrichtung durch verdunstende flüssige Anteile der Abdeckschicht (6) und der Zwischenschicht (7) vermieden. Im Bereich der Metallisierungseinrichtung (9) wird die Folie (2) oberhalb des Verdampfers (19) geführt, der den in Richtung auf die Folie (2) aufsteigenden Metalldampf (18) erzeugt. Der Metalldampf (18) schlägt sich auf der Folie bzw. den dem Verdampfer (19) zugewandten Bereichen Abdeckschicht (6) und der Zwischenschicht (7) nieder.

Nach ihrer Bedampfung wird die Folie der Lösungsmittelstation (12) zugeführt, in der sie vom Lösungsmittel (5) beaufschlagt wird. Das Lösungsmittel (5) dringt durch die im Bereich der Abdeckschicht (6) nur dünne Metallschicht (3) in die Abdeckschicht (6) ein und löst diese von der sie tragenden Unterlage. Gemeinsam mit der Abdeckschicht (6) wird auch die auf dieser aufhaftende Metallschicht (3) abgelöst. Nach der Ablösung der Abdeckschicht (6) gibt das Sichtfenster (4) den Blick auf die Folie (2) bzw. die im Bereich des Sichtfensters (4) angeordnete Zwischenschicht (7) frei. Das Sichtfenster (4) ist von scharfkantigen Begrenzungen der Metallschicht (3) umrandet. Dies resultiert daraus, daß das Sichtfenster (4) vor der Herauslösung der Abdeckschicht (6) durch die Abdeckschicht (6) ausgefüllt war. Da das Lösungsmittel (5) keine die Metallschicht (3) oder Druckfarben lösenden Eigenschaften aufweist, wird die Begrenzung des Sichtfensters (4) in der im Bereich der Metallschicht (3) liegenden Ebene durch das Lösungsmittel (5) auch nicht angegriffen.

Vor ihrer Aufwicklung auf der Sekundärrolle (14) wird die Folie (2) im Bereich des Sekundärtrockners (23) einer weiteren Trocknung unterworfen, um eine Aufeinanderhaftung der auf der Sekundärrolle (14) aufgewickelten Folienbahnen zu vermeiden.

## Patentansprüche

1. Verfahren zur Herstellung einer Folie (2), die auf mindestens einer ihrer Oberflächen (1) eine von mindestens einem Sichtfenster (4) unterbrochene Metallschicht (3) aufweist, das in einem mit einer löslichen Abdeckschicht (6) bedeckten Bereich der Oberfläche (1) aus der Metallschicht (3) herausgelöst wird, die auf die Oberfläche (1) im Vakuum aufgedapmft wird, dadurch gekennzeichnet, daß die Oberflächenspannung der Abdeckschicht (6) mit einem Benetzungsmittel herabgesetzt wird, durch das eine Oberflächenstruktur einer die Abdeckschicht (6) bildenden Substanz vergrößert wird und auf die Abdeckschicht (6) ein Lösungsmittel (5) aufgetragen und dadurch die Abdeckschicht (6) abgelöst wird.

2. Verfahren nach Anspruch 1, dadurch gekennzeichnet, daß eine wasserlösliche Abdeckschicht (6) mit Wasser von der Folie (2) abgelöst wird.

3. Verfahren nach Anspruch 1 und 2, dadurch gekennzeichnet, daß die Folie (2) im Bereich des Sichtfensters (4) mit einer umweltfreundlichen Abdeckschicht (6) bedeckt wird.

4. Verfahren nach einem der Ansprüche 1 bis 3, dadurch gekennzeichnet, daß die Folie (2) im Bereich des Sichtfensters (4) mit einer Abdeckschicht (6) bedeckt wird, die von dem sie auflösenden Lösungsmittel (5) in eine umweltfreundliche Lösung aufgelöst wird.

5. Verfahren nach einem der Ansprüche 1 bis 4, dadurch gekennzeichnet, daß das Lösungsmittel (5) mit einem seifigen Benetzungsmittel vermengt wird.

6. Verfahren nach einem der Ansprüche 1 bis 5, dadurch gekennzeichnet, daß die Folie (2) zur Ablösung der Abdeckschicht (6) durch ein Tauchbad (22) gezogen wird.

7. Verfahren nach einem der Ansprüche 1 bis 6, dadurch gekennzeichnet, daß die Folie (2) zur Ablösung der Abdeckschicht (6) mit den Lösungsmittel besprüht wird.

8. Verfahren nach den Ansprüchen 6 und 7, dadurch gekennzeichnet, daß die Folie (2) zur Ablösung der Abdeckschicht (6) sowohl durch ein Tauchbad (22) gezogen als auch mit dem Lösungsmittel (5) besprüht wird.

9. Verfahren nach Anspruch 1 bis 4, dadurch gekennzeichnet, daß die Folie (2) mit Lösungsmitteldampf beaufschlagt wird.

10. Verfahren nach einem der Ansprüche 1 bis 6, dadurch gekennzeichnet, daß die Folie (2) im Lösungsmittelbad (22) mit gegenläufig an ihr vorbeiströmendem Lösungsmittel (5) beaufschlagt wird.

11. Verfahren nach den Ansprüchen 6 und 10, dadurch gekennzeichnet, daß die Folie (2) im Bereich des Lösungsmittelbades (22) von einem Säuberungselement (40) gereinigt wird.

12. Verfahren nach Anspruch 1 bis 11, dadurch gekennzeichnet, daß die Folie (2) zur Ablösung der Abdeckschicht (6) von einer lösungsmittelauftragenden Walze (36) beaufschlagt wird.

13. Verfahren nach einem oder mehreren der Ansprüche 1 bis 12, dadurch gekennzeichnet, daß die Folie (2) zur Ablösung der Abdeckschicht (6) von mindestens einer lösungsmittelauftragenden Bürste (37) beaufschlagt wird.

14. Verfahren nach einem oder mehreren der Ansprüche 1 bis 13, dadurch gekennzeichnet, daß die Folie (2) zur Ablösung der Abdeckschicht (6) von mindestens einer lösungsmittelauftragenden Wischeinrichtung (39) beaufschlagt wird.

15. Verfahren nach einem oder mehreren der Ansprüche 1 bis 14, dadurch gekennzeichnet, daß die Abdeckschicht (6) unmittelbar auf die Oberfläche der Folie (2) aufgebracht wird.

16. Verfahren nach einem oder mehreren der Ansprüche 1 bis 14, dadurch gekennzeichnet, daß zunächst mindestens eine Zwischenschicht (7) auf die Folie (2) aufgebracht und anschließend die Abdeckschicht (6) auf die Zwischenschicht (7) aufgebracht wird.

17. Verfahren nach einem oder mehreren der Ansprüche 1 bis 15, dadurch gekennzeichnet, daß die Abdeckschicht (6) aufgedruckt wird.

18. Verfahren nach Anspruch 17, dadurch gekennzeichnet, daß die Abdeckschicht (6) im Tiefdruckverfahren aufgedruckt wird.

19. Verfahren nach Anspruch 17, dadurch gekennzeichnet, daß die Abdeckschicht (6) im Flexodruckverfahren aufgedruckt wird.

20. Verfahren nach den Ansprüchen 16 bis 19, dadurch gekennzeichnet, daß mehrere Zwischenschichten (7) auf die Folie (2) aufgebracht werden.

21. Verfahren nach Anspruch 20, dadurch gekennzeichnet, daß auf die Folie (2) zunächst mindestens eine Farb- und anschließend mindestens eine Lackschicht aufgebracht wird.

22. Verfahren nach Anspruch 20, dadurch gekennzeichnet, daß auf die Folie (2) zunächst mindestens eine Lackschicht und anschließend mindestens eine Farbschicht aufgebracht wird.

23. Verfahren nach einem oder mehreren der Ansprüche 16 bis 22, dadurch gekennzeichnet, daß die Folie (2) zunächst mindestens bereichsweise mit der Abdeckschicht (6) und anschließend mindestens bereichsweise mit mindestens einer Zwischenschicht (7) bedeckt wird.

24. Verfahren nach einem oder mehreren der Ansprüche 16 bis 23, dadurch gekennzeichnet, daß die Zwischenschicht (7) aufgedruckt wird.

25. Verfahren nach Anspruch 24, dadurch gekennzeichnet, daß die Zwischenschicht (7) im Tiefdruckverfahren aufgedruckt wird.

26. Verfahren nach Anspruch 24, dadurch gekennzeichnet, daß die Zwischenschicht (7) im Flexodruckverfahren aufgedruckt wird.

27. Verfahren nach einem oder mehreren der Ansprüche 1 bis 26, dadurch gekennzeichnet, daß die Metallschicht (3) durch Vakuummetallisierung auf die Folie (2) aufgebracht wird.

28. Folie mit einer Oberfläche (1), die mit einer Metallschicht (3) bedeckt ist, von der mindestens ein Teil über mindestens eine wasserlösliche Abdeckschicht (6) auf der Oberfläche (1) haftet und die Metallschicht (3) unter Verwendung von Wasser ablösbar ist, dadurch gekennzeichnet, daß die Abdeckschicht (6) aus einer mit einem beigemischten Benetzungsmittel versehenen Substanz besteht, die eine durch das Benetzungsmittel vergrößerte Oberflächenstruktur aufweist und gemeinsam mit der sie bedeckenden Metallschicht (3) durch Zugabe von Wasser von ihrem Untergrund ablösbar ist.

29. Folie nach Anspruch 28, dadurch gekennzeichnet, daß die Abdeckschicht (6) wasserlöslich ausgebildet ist.

30. Folie nach Anspruch 28 und 29, dadurch gekennzeichnet, daß die Abdeckschicht (6) eine große Oberfläche aufweist.

31. Folie nach Anspruch 30, dadurch gekennzeichnet, daß die Abdeckschicht (6) Anteile von oberflächenvergrößernden Produkten aufweist.

32. Folie nach Anspruch 31, dadurch gekennzeichnet, daß die Abdeckschicht (6) einen Anteil von Kieselsäureprodukten aufweist.

33. Folie nach einem oder mehreren der Ansprüche 28 bis 32, dadurch gekennzeichnet, daß die Abdeckschicht (6) im ungetrockneten Zustand einen Alkoholanteil aufweist.

34. Folie nach einem oder mehreren der Ansprüche 28 bis 33, dadurch gekennzeichnet, daß sie im wesentlichen wasserunlöslich ausgebildet ist.

35. Folie nach einem oder mehreren der Ansprüche 28 bis 33, dadurch gekennzeichnet, daß sie mindestens im Bereich ihrer Oberfläche (1) im wesentlichen wasserunlöslich ausgebildet ist.

36. Folie nach einem oder mehreren der Ansprüche 28 bis 35, dadurch gekennzeichnet, daß sie mindestens im Bereich ihrer Oberflächen (1) im wesentlichen quellbeständig ausgebildet ist.

37. Folie nach einem oder mehreren der Ansprüche 28 bis 36, dadurch gekennzeichnet, daß sie im wesentlichen aus Polyester ausgebildet ist.

38. Folie nach einem oder mehreren der Ansprüche 28 bis 36, dadurch gekennzeichnet, daß sie im wesentlichen aus Polypropylen ausgebildet ist.

39. Folie nach einem oder mehreren der Ansprüche 28 bis 36, dadurch gekennzeichnet, daß sie im wesentlichen aus Polystyrol ausgebildet ist.

40. Folie nach einem oder mehreren der Ansprüche 28 bis 36, dadurch gekennzeichnet, daß sie im wesentlichen aus Polyethylen ausgebildet ist.

41. Folie nach einem oder mehreren der Ansprüche 28 bis 40, dadurch gekennzeichnet, daß zwischen der Metallschicht (3) und der Folie (2) mindestens eine Zwischenschicht (7) angeordnet ist.

42. Folie nach einem oder mehreren der Ansprüche 28 bis 41, dadurch gekennzeichnet, daß die Abdeckschicht (6) unmittelbar auf der Folie (2) angeordnet ist.

43. Folie nach einem oder mehreren der Ansprüche 28 bis 41, dadurch gekennzeichnet, daß die Abdeckschicht (6) im Bereich der der Metallschicht (3) zugewandten Oberfläche der Zwischenschicht (7) angeordnet ist.

44. Folie nach einem oder mehreren der Ansprüche 28 bis 43, dadurch gekennzeichnet, daß die Zwischenschicht (7) mindestens bereichsweise gefärbt ist.

45. Folie nach einem oder mehreren der Ansprüche 28 bis 44, dadurch gekennzeichnet, daß die Zwischenschicht (7) als Lack ausgebildet ist.

46. Folie nach einem oder mehreren der Ansprüche 28 bis 44, dadurch gekennzeichnet, daß die Zwischenschicht (7) als Druckfarbe ausgebildet ist.

47. Folie nach einem oder mehreren der Ansprüche 28 bis 46, dadurch gekennzeichnet, daß die Abdeckschicht (6) als UV-reflektierende Substanz ausgebildet ist.

48. Vorrichtung zur Herstellung einer Folie (2), die eine Metallisierungseinrichtung (9) zur Bedampfung mindestens einer Oberfläche (1) der Folie (2) mit einer Metallschicht (3) und eine in Förderrichtung der Folie (2) hinter der Metallisierungseinrichtung (9) angeordnete Lösungsmittelstation (12) zur Ablösung mindestens eines Teils der Metallschicht (3) von einer Abdeckschicht (6) aufweist, die aus einer wasserlöslichen Substanz besteht und von einem Druckwerk (11) aufgedruckt wird, das in Förderrichtung der Folie (2) vor der Metallisierungseinrichtung (9) angeordnet ist, zwischen der und dem Druckwerk (11) ein Primärtrockner (16) angeordnet ist, dadurch gekennzeichnet, daß zwischen dem Primärtrocker (16) und dem Druckwerk (11) mindestens ein weiteres Druckwerk (15) zum Aufdruck weiterer Schichten vorgesehen ist, die zwischen der mit einer oberflächenvergrößernden Substanz versehenen Abdeckschicht (6) und der Metallschicht (3) angeordnet sind, und in der Lösungsmittelstation (12) eine die Metallschicht (3) unter dem Einfluß des Lösungsmittels (5) von der Abdeckschicht (6) ablösende Ablösevorrichtung (36, 37, 39) vorgesehen ist.

49. Vorrichtung nach Anspruch 48, dadurch gekennzeichnet, daß der Primärtrockner (16) im Bereich des Druckwerks (11) angeordnet ist.

50. Vorrichtung nach einem der beiden Ansprüche 48 und 49, dadurch gekennzeichnet, daß zwischen der Lösungsmittelstation (12) und einer die Folie (2) aufwickelnden Sekundärrolle (14) ein die Folie (2) trocknender Sekundärtrockner (23) angeordnet ist.

51. Vorrichtung nach einem oder mehreren der Ansprüche 48 bis 50, dadurch gekennzeichnet, daß zwischen dem Druckwerk (11) und dem Primärtrockner (16) mindestens ein die Folie (2) mit einer Zwischenschicht (7) bedruckendes Druckwerk (15) angeordnet ist.

52. Vorrichtung nach einem oder mehreren der Ansprüche 48 bis 51, dadurch gekennzeichnet, daß zwischen einer die Folie (2) abwickelnden Primärrolle (13) und dem Druckwerk (11) mindestens ein die Folie (2) mit jeweils einer Zwischenschicht (7) bedruckendes Druckwerk (15) angeordnet ist.

53. Vorrichtung nach einem oder mehreren der Ansprüche 48 bis 52, dadurch gekennzeichnet, daß im Bereich der Lösungsmittelstation (12) mindestens ein die Folie (2) mit Lösungsmittel (5) besprühender Sprühkopf (21) angeordnet ist.

54. Vorrichtung nach einem oder mehreren der Ansprüche 48 bis 53, dadurch gekennzeichnet, daß im Bereich der Lösungsmittelstation (12) mindestens ein die Folie (2) mit Lösungsmittel (5) beaufschlagendes Lösungsmittelbad (22) angeordnet ist.

55. Vorrichtung nach einem oder mehreren der Ansprüche 48 bis 54, dadurch gekennzeichnet, daß im Bereich der Lösungsmittelstation (12) mindestens eine die Folie (2) mit Lösungsmittel (5) beaufschlagende Ablösewalze (36) angeordnet ist.

56. Vorrichtung nach einem oder mehreren der Ansprüche 48 bis 55, dadurch gekennzeichnet, daß im Bereich der Lösungsmittelstation (12) mindestens eine die Folie (2) mit Lösungsmittel (5) beaufschlagende Ablösebürste (37) angeordnet ist.

57. Vorrichtung nach einem oder mehreren der Ansprüche 48 bis 56, dadurch gekennzeichnet, daß im Bereich der Lösungsmittelstation (12) mindestens eine die Folie (2) mit Lösungsmitteldampf beaufschlagende Ablösedampfdüse (38) angeordnet ist.

58. Vorrichtung nach einem oder mehreren der Ansprüche 48 bis 57, dadurch gekennzeichnet, daß im Bereich der Lösungsmittelstation (12) mindestens eine die Folie (2) wischend mit Lösungsmittel (5) beaufschlagende Ablösewischvorrichtung (39) angeordnet ist.

## Claims

1. A process for the production of a foil (2) which on at least one of its surfaces (1) has a metal layer (3) interrupted by at least one viewing window (4) which in a region of the surface (1) which is covered with a soluble cover layer (6) is dissolved out of the metal layer (3) which is vapour-deposited on the surface (1) in a vacuum characterised in that the surface tension of the cover layer (6) is reduced by a wetting agent by which a surface structure of a substance forming the cover layer (6) is increased in size and a solvent (5) is applied to the cover layer (6) and thereby the cover layer (6) is dissolved away.

2. A process according to claim 1 characterised in that a water-soluble cover layer (6) is dissolved off the foil (2) with water.

3. A process according to claim 1 and claim 2 characterised in that in the region of the window (4) the foil (2) is covered with an environmentally friendly cover layer (6).

4. A process according to one of claim 1 to 3 characterised in that in the region of the window (4) the foil (2) is covered with a cover layer (6) which is dissolved into an environmentally friendly solution by the solvent (5) which dissolves the cover layer.

5. A process according to one of claims 1 to 4 characterised in that the solvent (5) is mixed with a soapy wetting agent.

6. A process according to one of claims 1 to 5 characterised in that the foil (2) is drawn through an immersion bath (22) for dissolving the cover layer (6) away.

7. A process according to claims 1 to 6 characterised in that the foil (2) is sprayed with the solvent for dissolving the cover layer (6) away.

8. A process according to claims 6 and 7 characterised in that the foil (2) is both drawn through an immersion bath (22) and also sprayed with the solvent (5) to dissolve the cover layer (6) away.

9. A process according to claims 1 to 4 characterised in that the foil (2) is acted upon by solvent vapour.

10. A process according to one of claims 1 to 6 characterised in that the foil (2) is acted upon in the solvent bath (22) with solvent (5) which flows past it in opposite relationship.

11. A process according to claims 6 and 10 characterised in that the foil (2) is cleaned in the region of the solvent bath (22) by a cleaning element (40).

12. A process according to claims 1 to 11 characterised in that the foil (2) is acted upon by a solvent-applying roller (36) to dissolve the cover layer (6) away.

13. A process according to one or more of claims 1 to 12 characterised in that the foil (2) is acted upon by at least one solvent-applying brush (37) to dissolve the cover layer (6) away.

14. A process according to one or more of claims 1 to 13 characterised in that the foil (2) is acted upon by at least one solvent-applying wiping device (39) to dissolve the cover layer (6) away.

15. A process according to one or more of claims 1 to 14 characterised in that the cover layer (6) is applied directly to the surface of the foil (2).

16. A process according to one or more of claims 1 to 14 characterised in that firstly at least one intermediate layer (7) is applied to the foil (2) and then the cover layer (6) is applied to the intermediate layer (7).

17. A process according to one or are of claims 1 to 15 characterised in that the cover layer (6) is applied by printing.

18. A process according to claim 17 characterised in that the cover layer (6) is applied by printing using the intaglio printing process.

19. A process according to claim 17 characterised in that the cover layer (6) is applied by printing using the flexographic printing process.

20. A process according to claims 16 to 19 characterised in that a plurality of intermediate layers (7) are applied to the foil (2).

21. A process according to claim 20 characterised in that firstly at least one ink layer is applied to the foil (2) and then at least one lacquer layer is applied to the foil.

22. A process according to claim 20 characterised in that firstly at least one lacquer layer is applied to the foil (2) and then at least one ink layer is applied to the foil.

23. A process according to one or more of claims 16 to 22 characterised in that the foil (2) is firstly at least region-wise covered with the cover layer (6) and then at least region-wise covered with at least one intermediate layer (7).

24. A process according to one or more of claims 16 to 23 characterised in that the intermediate layer (7) is applied by printing.

25. A process according to claim 24 characterised in that the intermediate layer (7) is applied by printing using the intaglio printing process.

26. A process according to claim 24 characterised in that the intermediate layer (7) is applied by printing using the flexographic printing process.

27. A process according to one or are of claims 1 to 26 characterised in that the metal layer (3) is applied to the foil (2) by vacuum metallisation.

28. A foil having a surface (1) which is covered by a metal layer (3) of which at least a part adheres to the surface (1) by way of at least one water-soluble cover layer (6) and the metal layer (3) can be dissolved away using water characterised in that the cover layer (6) comprises a substance which is provided with an added wetting agent and which has a surface structure that is increased in size by the wetting agent, which substance can be dissolved away from its substrate together with the metal layer (3) covering it by the addition of water.

29. A foil according to claim 28 characterised in that the cover layer (6) is water-soluble.

30. A foil according to claim 28 and claim 29 characterised in that the cover layer (6) has a large surface area.

31. A foil according to claim 30 characterised in that the cover layer (6) has portions of surface area-enlarging products.

32. A foil according to claim 31 characterised in that the cover layer (6) has a portion of silicic acid products.

33. A foil according to one or more of claims 28 to 32 characterised in that the cover layer (6) in the undried condition has an alcohol component.

34. A foil according to one or more of claims 28 to 33 characterised in that it is substantially water-insoluble.

35. A foil according to one or more of claims 28 to 33 characterised in that it is substantially water-insoluble at least in the region of its surface (1).

36. A foil according to one or are of claims 28 to 35 characterised in that it is substantially swelling-resistant at least in the region of its surface (1).

37. A foil according to one or are of claims 28 to 36 characterised in that it is substantially formed from polyester.

38. A foil according to one or more of claims 28 to 36 characterised in that it is substantially formed from polypropylene.

39. A foil according to one or more of claims 28 to 36 characterised in that it is substantially formed from polystyrene.

40. A foil according to one or are of claims 28 to 36 characterised in that it is substantially formed from polyethylene.

41. A foil according to one or more of claims 28 to 40 characterised in that at least one intermediate layer (7) is arranged between the metal layer (3) and the foil (2).

42. A foil according to one or more of claims 28 to 41 characterised in that the cover layer (6) is arranged directly on the foil (2).

43. A foil according to one or more of claims 28 to 41 characterised in that the cover layer (6) is arranged in the region of the surface of the intermediate layer (7), that is towards the metal layer (3).

44. A foil according to one or more of claims 28 to 43 characterised in that the intermediate layer (7) is at least region-wise coloured.

45. A foil according to one or more of claims 28 to 44 characterised in that the intermediate layer (7) is in the form of a lacquer.

46. A foil according to one or more of claims 28 to 44 characterised in that the intermediate layer (7) is in the form of a printing ink.

47. A foil according to one or more of claims 28 to 46 characterised in that the cover layer (6) is in the form of an UV-reflecting substance.

48. Apparatus for producing a foil (2) which has a metallisation device (9) for the vapour deposit on at least one surface (1) of the foil (2) of a metal layer (3) and a solvent station (12) which is arranged downstream of the metallisation device (9) in the direction of conveying movement of the foil (2) for dissolving at least a part of the metal layer (3) off a cover layer (6) which comprises a water-soluble substance and which is applied by printing by a printing mechanism (11) which is arranged in the direction of conveying movement of the foil (2) upstream of the metallisation device (9), between which and the printing mechanism (11) a primary drier (16) is arranged, characterised in that provided between the primary drier (16) and the printing mechanism (11) is at least one further printing mechanism (15) for applying by printing further layers which are arranged between the metal layer (3) and the cover layer (6) which is provided with a surface area-enlarging substance, and provided in the solvent station (12) is a dissolving device (36, 37, 39) for dissolving the metal layer (3) off the cover layer (6) under the influence of the solvent (5).

49. Apparatus according to claim 48 characterised in that the primary drier (16) is arranged in the region of the printing mechanism (11).

50. Apparatus according to one of claims 48 and 49 characterised in that a secondary drier (23) for drying the foil (2) is arranged between the solvent station (12) and a secondary roller (14) for winding on the foil (2).

51. Apparatus according to one or more of claims 48 to 50 characterised in that disposed between the printing mechanism (11) and the primary drier (16) is at least one printing mechanism (15) which prints an intermediate layer (7) on the foil (2).

52. Apparatus according to one or more of claims 48 to 51 characterised in that arranged between a primary roller (13) which unwinds the foil (2) and the printing mechanism (11) is at least one printing mechanism (15) which prints a respective intermediate layer (7) on the foil (2).

53. Apparatus according to one or are of claims 48 to 52 characterised in that a spray head (21) for spraying the foil (2) with solvent (5) is arranged in the region of the solvent station (12).

54. Apparatus according to one or more of claims 48 to 53 characterised in that at least one solvent bath (22) for acting upon the foil (2) with solvent (5) is arranged in the region of the solvent station (12).

55. Apparatus according to one or are of claims 48 to 54 characterised in that at least one dissolving roller (36) which acts on the foil (2) with solvent (5) is arranged in the region of the solvent station (12).

56. Apparatus according to one or more of claims 48 to 55 characterised in that at least one dissolving brush (37) which acts on the foil (2) with solvent (5) is arranged in the region of the solvent station (12).

57. Apparatus according to one or are of claims 48 to 56 characterised in that at least one dissolving vapour nozzle (38) which acts on the foil (2) with solvent vapour is arranged in the region of the solvent station (12).

58. Apparatus according to one or more of claims 48 to 57 characterised in that at least one dissolving wiping device (39) which acts on the foil (2) with a wiping action with solvent (5) is arranged in the region of the solvent station (12).

## Revendications

1. Procédé pour la fabrication d'une feuille (2), qui présente sur l'une au moins de ses surfaces (1) une couche métallique (3) qui est interrompue par au moins une fenêtre (4) ménagée par dissolution dans une zone de la surface (1) recouverte par une couche de couverture (6) soluble, et qui est appliquée par vaporisation sous vide sur la surface (1), caractérisé en ce que la tension superficielle de la couche de couverture (6) est abaissée avec un agent mouillant, par lequel une structure de surface d'une substance formant la couche de couverture (6) est agrandie, et un solvant (5) est appliqué sur la couche de couverture (6) et dissout la couche de couverture (6).

2. Procédé selon la revendication 1, caractérisé en ce qu'une couche de couverture (6) hydrosoluble est dissoute sur la feuille (2) avec de l'eau.

3. Procédé selon les revendications 1 et 2, caractérisé en ce que la feuille (2) est recouverte dans la zone de la fenêtre (4) d'une couche de couverture (6) compatible avec l'environnement.

4. Procédé selon l'une quelconque des revendications 1 à 3, caractérisé en ce que la feuille (2) est recouverte dans la zone de la fenêtre (4) par une couche de couverture (6) qui est dissoute par le solvant (5) qui la dissout en une solution compatible avec l'environnement.

5. Procédé selon l'une quelconque des revendications 1 à 4, caractérisé en ce que le solvant (5) est additionné d'un agent mouillant savonneux.

6. Procédé selon l'une quelconque des revendications 1 à 5, caractérisé en ce que la feuille (2) est passée dans un bain d'immersion (22) pour dissoudre la couche de couverture (6).

7. Procédé selon l'une quelconque des revendications 1 à 6, caractérisé en ce que le solvant est pulvérisé sur la feuille (2) pour dissoudre la couche de couverture (6).

8. Procédé selon les revendications 6 et 7, caractérisé en ce que la feuille (2) est aussi bien passée dans un bain d'immersion (22) qu'exposée a une pulvérisation de solvant (5) pour dissoudre la couche de couverture (6).

9. Procédé selon l'une quelconque des revendications 1 à 4, caractérisé en ce que la feuille (2) est exposée à de la vapeur de solvant.

10. Procédé selon l'une quelconque des revendications 1 à 6, caractérisé en ce que la feuille (2) est exposée dans le bain de solvant (22) à du solvant (5) circulant sur elle à contre-sens.

11. Procédé selon les revendications 6 et 10, caractérisé en ce que la feuille (2) est nettoyée dans la zone du bain de solvant (22) par un élément nettoyant (40).

12. Procédé selon l'une quelconque des revendications 1 à 11, caractérisé en ce que la feuille (2) est exposée à un rouleau (36) appliquant le solvant pour dissoudre la couche de couverture (6).

13. Procédé selon l'une ou l'ensemble des revendications 1 à 12, caractérisé en ce que la feuille (2) est exposée a au moins une brosse (37) appliquant le solvant pour dissoudre la couche de couverture (6).

14. Procédé selon l'une ou l'ensemble des revendications 1 à 13, caractérisé en ce que la feuille (2) est exposée à au moins un dispositif d'essuyage (39) appliquant le solvant pour dissoudre la couche de couverture (6).

15. Procédé selon l'une ou l'ensemble des revendications 1 à 14, caractérisé en ce que la couche de couverture (6) est appliquée directement sur la surface de la feuille (2).

16. Procédé selon l'une ou l'ensemble des revendications 1 à 14, caractérisé en ce qu'au moins une couche intermédiaire (7) est d'abord appliquée sur la feuille (2) et la couche de couverture (6) est ensuite appliquée sur la couche intermédiaire (7).

17. Procédé selon l'une ou l'ensemble des revendications 1 à 15, caractérisé en ce que la couche de couverture (6) est appliquée par impression.

18. Procédé selon la revendication 17, caractérisé en ce que la couche de couverture (6) est appliquée selon un procédé d'impression en creux.

19. Procédé selon la revendication 17, caractérisé en ce que la couche de couverture (6) est appliquée selon un procédé flexographique.

20. Procédé selon les revendications 16 à 19, caractérisé en ce que plusieurs, couches intermédiaires (7) sont appliquées sur la feuille (2).

21. Procédé selon la revendication 20, caractérisé en ce qu'au moins une couche d'encre, puis une couche de vernis sont appliquées sur la feuille (2).

22. Procédé selon la revendication 20, caractérisé en ce qu'au moins une couche de vernis, puis au moins une couche d'encre sont appliquées sur la feuille (2).

23. Procédé selon l'une ou l'ensemble des revendications 16 à 22, caractérisé en ce que la feuille (2) est d'abord recouverte par endroits de la couche de couverture (6), puis au moins par endroits d'au moins une couche intermédiaire (7).

24. Procédé selon l'une ou l'ensemble des revendications 16 à 23, caractérisé en ce que la couche intermédiaire (7) est appliquée par impression.

25. Procédé selon la revendication 24, caractérisé en ce que la couche intermédiaire (7) est appliquée selon un procédé d'impression en creux.

26. Procédé selon la revendication 24, caractérisé en ce que la couche intermédiaire (7) est appliquée selon un procédé flexographique.

27. Procédé selon l'une ou l'ensemble des revendications 1 à 26, caractérisé en ce que la couche métallique (3) est appliquée sur la feuille (2) par métallisation sous vide.

28. Feuille avec une surface (1) recouverte d'une couche métallique (3), dont au moins une partie adhère à la surface (1) par l'intermédiaire d'au moins une couche de couverture (6) hydrosoluble et la couche métallique (3) peut être détachée en utilisant de l'eau, caractérisée en ce que la couche de couverture (6) se compose d'une substance pourvue d'un agent mouillant ajouté, qui présente une structure de surface agrandie par l'agent mouillant et qui peut être détachée de son support en même temps que la couche métallique (3) qui la recouvre en présence d'eau.

29. Feuille selon la revendication 28, caractérisée en ce que la couche de couverture (6) est hydrosoluble.

30. Feuille selon les revendications 28 et 29, caractérisée en ce que la couche de couverture (6) présente une grande surface.

31. Feuille selon la revendication 30, caractérisée en ce que la couche de couverture (6) présente des parts de produits agrandissant la surface.

32. Feuille selon la revendication 31, caractérisée en ce que la couche de couverture (6) présente une part de produits à base d'acide silicique.

33. Feuille selon l'une ou l'ensemble des revendications 28 à 32, caractérisée en ce que la couche de couverture (6) présente a l'état non séché une part d'alcool.

34. Feuille selon l'une ou l'ensemble des revendications 28 à 33, caractérisée en ce qu'elle est sensiblement insoluble dans l'eau.

35. Feuille selon l'une ou l'ensemble des revendications 28 à 33, caractérisée en ce qu'elle est sensiblement insoluble dans l'eau au moins dans la région de sa surface (1).

36. Feuille selon l'une ou l'ensemble des revendications 28 à 35, caractérisée en ce qu'elle est sensiblement insensible au gonflement au moins dans la zone de ses surfaces (1).

37. Feuille selon l'une ou l'ensemble des revendications 28 à 36, caractérisée en ce qu'elle se compose pour l'essentiel de polyester.

38. Feuille selon l'une ou l'ensemble des revendications 28 à 36, caractérisée en ce qu'elle se compose pour l'essentiel de polypropylène.

39. Feuille selon l'une ou l'ensemble des revendications 28 à 36, caractérisée en ce qu'elle se compose pour l'essentiel de polystyrène.

40. Feuille selon l'une ou l'ensemble des revendications 28 à 36, caractérisée en ce qu'elle se compose pour l'essentiel de polyéthylène.

41. Feuille selon l'une ou l'ensemble des revendications 28 à 40, caractérisée en ce qu'au moins une couche intermédiaire (7) est disposée entre la couche métallique (3) et la feuille (2).

42. Feuille selon l'une ou l'ensemble des revendications 28 à 41, caractérisée en ce que la couche de couverture (6) est disposée directement sur la feuille (2).

43. Feuille selon l'une ou l'ensemble des revendications 28 à 41, caractérisée en ce que la couche de couverture (6) est disposée dans la zone de la surface de la couche intermédiaire (7) orientée vers la couche métallique (3).

44. Feuille selon l'une ou l'ensemble des revendications 28 à 43, caractérisée en ce que la couche intermédiaire (7) est colorée au moins par endroits.

45. Feuille selon l'une ou l'ensemble des revendications 28 à 44, caractérisée en ce que la couche intermédiaire (7) se compose de vernis.

46. Feuille selon l'une ou l'ensemble des revendications 28 à 44, caractérisée en ce que la couche intermédiaire (7) se compose d'encre.

47. Feuille selon l'une ou l'ensemble des revendications 28 à 46, caractérisée en ce que la couche de couverture (6) se compose d'une substance réfléchissant les ultra-violets.

48. Dispositif pour la fabrication d'une feuille (2), qui présente une installation de métallisation (9) pour le dépôt par vaporisation d'une couche métallique (3) sur moins une surface (1) de la feuille (2) et un poste de solvant (12) disposé en aval de l'installation de métallisation (9) dans le sens de transport de la feuille (2) et destiné à détacher au moins une partie de la couche métallique (3) d'une couche de couverture (6), qui se compose d'une substance hydrosoluble et qui est appliquée par un mécanisme d'imprimerie (11) disposé en amont de l'installation de métallisation (9) dans le sens de transport de la feuille (2), un séchoir primaire (16) étant disposé entre celle-ci et le mécanisme d'impression (11), caractérisé en ce qu'il est prévu entre le séchoir primaire (16) et le mécanisme d'impression (11) au moins un autre mécanisme d'impression (15) pour l'application d'autres couches, qui sont disposées entre la couche de couverture (6) pourvue d'une substance agrandissant sa surface et la couche métallique (3), et il est prévu dans le poste de solvant (12) un dispositif de détachement (36, 37, 39) qui détache la couche métallique (3) de la couche de couverture (6) sous l'influence du solvant (5).

49. Dispositif selon la revendication 48, caractérisé en ce que le séchoir primaire (16) est disposé dans la zone du mécanisme d'impression (11).

50. Dispositif selon l'une des deux revendications 48 et 49, caractérisé en ce qu'un séchoir secondaire (23) séchant la feuille (2) est disposé entre le poste de solvant (12) et un rouleau secondaire (14) qui enroule la feuille (2).

51. Dispositif selon l'une ou l'ensemble des revendications 48 à 50, caractérisé en ce qu'au moins un mécanisme d'impression (15) imprimant une couche intermédiaire (7) sur la feuille (2) est disposé entre le mécanisme d'impression (11) et le séchoir primaire (16).

52. Dispositif selon l'une ou l'ensemble des revendications 48 à 51, caractérisé en ce qu'au moins un mécanisme d'impression (15) appliquant chacun une couche intermédiaire (7) sur la feuille (2) est disposé entre un rouleau primaire (13) qui déroule la feuille (2) et le mécanisme d'impression (11).

53. Dispositif selon l'une ou l'ensemble des revendications 48 à 52, caractérisé en ce qu'une tête de pulvérisation (21) pulvérisant du solvant (5) sur la feuille (2) est disposée dans la zone du poste de solvant (12).

54. Dispositif selon l'une ou l'ensemble des revendications 48 à 53, caractérisé en ce qu'au moins un bain de solvant (22) exposant la feuille (2) au solvant (5) est disposé dans la zone du poste de solvant (12).

55. Dispositif selon l'une ou l'ensemble des revendications 48 à 54, caractérisé en ce qu'au moins un rouleau de détachement (36) exposant la feuille (2) au solvant (5) est disposé dans la zone du poste de solvant (12).

56. Dispositif selon l'une ou l'ensemble des revendications 48 à 55, caractérisé en ce qu'au moins une brosse de détachement (37) exposant la feuille (2) au solvant (5) est disposée dans la zone du poste de solvant (12).

57. Dispositif selon l'une ou l'ensemble des revendications 48 à 56, caractérisé en ce qu'au moins une buse à vapeur de détachement (38) exposant la feuille (2) à de la vapeur de solvant est disposée dans la zone du poste de solvant (12).

58. Dispositif selon l'une ou l'ensemble des revendications 48 à 57, caractérisé en ce qu'au moins un dispositif d'essuyage de détachement (39), qui essuie la feuille (2) pour l'exposer au solvant (5), est disposé dans la zone du poste de solvant (12).
